# EUROPEAN PATENT APPLICATION

(11) **EP 3 460 862 A1**
(43) Date of publication of application: **27.03.2019**
(21) Application number: 17799052.0
(22) Date of filing: 05.04.2017
(51) Int. Cl.: H01L 49/00

(54) **SECONDARY BATTERY MANUFACTURING METHOD**

(30) Priority: 19.05.2016 JP 2016100875; 15.03.2017 JP 2017049257
(71) Applicant: Kabushiki Kaisha Nihon Micronics, Musashino-shi, Tokyo 180-8508 (JP)
(72) Inventor: TSUNOKUNI, Kazuyuki, Musashino-shi, Tokyo 180-8508, (JP); SAITO, Tomokazu, Musashino-shi, Tokyo 180-8508, (JP); SATO, Yuki, Musashino-shi, Tokyo 180-8508, (JP); TAKANO, Hikaru, Musashino-shi, Tokyo 180-8508, (JP)
(74) Representative: Leinweber & Zimmermann
(86) International application number: PCT/JP2017/014164
(87) International publication number: WO 2017/199618

(57) **Abstract**

To provide a manufacturing method of a secondary battery capable of increasing discharge capacity.

The method of manufacturing a secondary battery according to the present invention comprises a first electrode 12, an n-type metal oxide semiconductor layer 14 made of an n-type metal oxide semiconductor, an n-type metal oxide semiconductor and an insulator An intermediate insulating layer 18 containing an insulator as a main component, a p-type metal oxide semiconductor layer 22 made of a p-type metal oxide semiconductor, and a second electrode 24 are laminated in this order , A first process of applying a positive voltage between the first electrode 12 and the second electrode 24 with reference to the first electrode 12 and a second process of applying a positive voltage between the first electrode 12 and the second electrode 24 And a second process in which 0 V is applied between the first process cycle and the second process cycle in this order is defined as a first unit cycle and a predetermined number of first unit cycles are repeated.

## Description

### Technical Field

The present invention relates to a method for manufacturing an all solid secondary battery.

### Background Art

As a device having a power storage function, there are a secondary battery and a capacitor. A secondary battery is a device utilizing a chemical reaction and is characterized by its large capacity. The capacitor is characterized in that charges are accumulated while sandwiching an insulator between the electrodes, so that it can be charged in a short time. Examples of secondary batteries include nickel-cadmium batteries and lithium ion secondary batteries. As a capacitor, there are a super capacitor (also called an electric double layer capacitor.), a MOS capacitor and the like.

A lithium ion secondary battery, which is a typical secondary battery, has a three-layer structure in which a separator is sandwiched between a positive electrode and a negative electrode, and these constituent elements are covered with an electrolyte capable of flowing lithium ions. The positive electrode and the negative electrode are materials capable of absorbing and releasing lithium ions and electrons. Inside the lithium ion battery, lithium ions move between the positive electrode and the negative electrode via the electrolyte to perform charging and discharging.

As a laminated structure of a solid lithium ion secondary battery, the structure disclosed in Patent Document 1 includes a positive electrode layer having a positive electrode active material into which lithium ions enter and exit, a negative electrode layer having a negative electrode active material into which lithium ions enter and exits, and a positive electrode And a solid electrolyte layer disposed between the anode layer and the anode layer. The solid electrolyte layers of the two adjacent laminates are connected by an insulating layer. Furthermore, the two adjacent laminates are laminated so that the anode layers constituting each laminate or the cathode layers constituting each laminate come into contact with each other.

As a secondary battery based on a new principle, Patent Document 2 discloses a quantum battery. "Quantum battery" is a name given to the secondary battery disclosed in Patent Document 2.

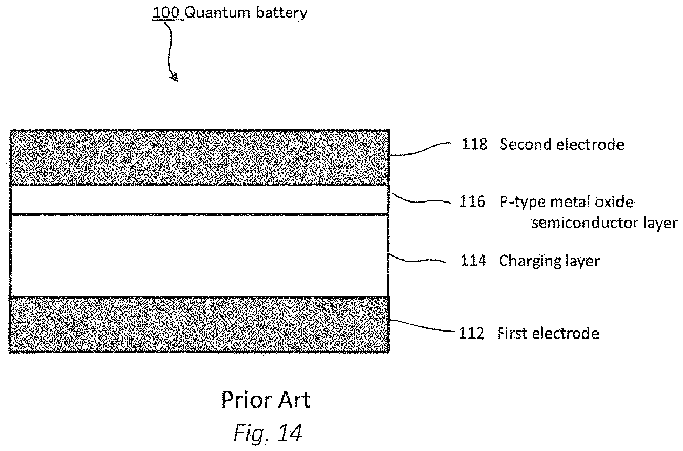

FIG. 14 is a diagram showing a cross section of the quantum battery 100. In the quantum battery 100, a conductive first electrode 312 is formed on a substrate, and a charge layer 114 for charging the charge, a p-type metal oxide semiconductor layer 116 and a second electrode 118 are stacked. The charging layer 114 is filled with fine particle n-type metal oxide semiconductor covered with an insulative film to generate a photoexcited structural change phenomenon by irradiation with ultraviolet light, thereby a new energy level is formed in a band gap of the n-type metal oxide semiconductor

In addition, Patent Document 3 discloses a new secondary battery in which a function of an electrochromic display device and a secondary battery are integrated using a semiconductor. What is claimed is: 1. A semiconductor device comprising: a substrate; a first electrode; a porous layer made of a semiconductor metal oxide; an active layer comprising a composite of a semiconductor metal oxide and an insulating metal oxide and reversibly generating an oxidation- , An electron blocking layer, and a second electrode, and structurally has the same structure as the quantum battery shown in FIG. The active layer accumulates or releases charges by oxidation-reduction reaction, and is used as an electrochromic display device / secondary battery integrated solid-state device whose light transmittance changes in conjunction with charge accumulation or release.

The difference between the quantum battery disclosed in Patent Document 2 and the secondary battery disclosed in Patent Document 3 is that, in the latter structure, the charge layer is a composite of a semiconductor metal oxide and an insulating metal oxide and that no new energy level is formed within the band gap of the n-type metal oxide semiconductor by ultraviolet irradiation. Due to these differences, in the latter case, the principle of charge and discharge is based on the reversible oxidation-reduction reaction between the semiconductor metal oxide and the insulating metal oxide.

In the secondary battery disclosed in Patent Document 3, the complex oxide thin film is changed to an active state by performing a photoexcitation structure change process on the complex oxide thin film, and as a photoexcited structure change process, a method based on ultraviolet irradiation can be used.

Processing performed after formation of the secondary battery includes aging treatment and conditioning treatment.

A lithium secondary battery includes an electrode body provided with a positive electrode and a negative electrode in a battery case, the battery case is sealed after the nonaqueous electrolyte is injected. After the formation of a lithium secondary battery, a so-called aging treatment in which the lithium secondary battery is stored at a predetermined temperature is performed thereafter, and performs conditioning processing for adjusting the battery to a state in which the battery can be actually usable by performing charging/discharging (refer to patent document 4).

Conditioning is to repeat the cycle of charging and discharging a plurality of times on the formed secondary battery for the purpose of stabilizing battery performance and the like. SEI (Solid Electrolyte Interphase) coating comprising a lithium-containing compound or the like is formed on the surface of the negative electrode by conditioning a lithium secondary battery using a carbonaceous material or the like as a negative electrode active material. Since the SEI film covering the surface of the negative electrode hardly grows, once the state of the SEI film does not change, the battery capacity stabilizes at this stage.

Patent Document 5 discloses a charge / discharge device that performs conditioning to a quantum battery using a metal oxide semiconductor (see Patent Document 2). When charging and discharging of a plurality of quantum batteries are performed in parallel at the same time, the peak current of the power supply increases, and therefore, in this charging device, the quantum battery are sequentially connected to the power supply are switched in order that the charging and discharging of the plurality of quantum cells do not overlap by the switching means.

### Prior art literature

### Patent document

Patent document 1: WO2010/089855
Patent document 2: WO2012/ 046325
Patent document 3: Japanese Patent Application Laid-Open No. 2014-032353
Patent document 4: Japanese Patent Application Laid-Open No. 2004-208440
Patent document 5: WO 2014/016900

### Summary of the invention

### Problem to be solved by the invention

Compared to lithium ion batteries and the like using electrolytic solution, the all solid state secondary battery is compact, does not ignite due to heat generation, has high safety but charge capacity is small, further improvement is demanded.

In addition, in order to adjust the secondary battery to a state where it can be actually used, aging processing and conditioning processing, which are electrical processing performed after the formation of the secondary battery, are performed. As described in the background art above, these electrical processes are conventionally performed in order to stabilize the initial charge function, and do not improve performance such as an increase in discharge capacity.

For this reason, electrical processing for increasing the discharge capacity is desired.

The present invention relates to electrical processing performed on a formed secondary battery, and by examining its electrical conditions, it is possible to increase the discharge capacity more than the initial discharge capacity of the secondary battery and to provide a manufacturing method therefor.

A method of manufacturing an oxide semiconductor secondary battery according to one embodiment of the present invention includes the steps of preparing a first electrode, an n-type metal oxide semiconductor layer made of an n-type metal oxide semiconductor, a charging layer made of an n-type metal oxide semiconductor and an insulator, an intermediate insulating layer containing an insulator as a main component, a p-type metal oxide semiconductor layer made of a p-type metal oxide semiconductor, and a second electrode are stacked in this order on the first electrode, and then the first unit cycle includes a first process of applying a positive voltage between the first electrode and the second electrode with reference to the first electrode and a second process of applying 0 V between the first electrode and the second electrode, and the first unit cycle is repeated with a predetermined number.

In the above manufacturing method, when the first electrode is grounded, the value of the positive voltage applied to the second electrode in the first process includes at least a value equal to or higher than the charging voltage of the oxide semiconductor secondary battery.

In the above manufacturing method, the first process includes a process of holding a state in which a positive voltage is applied between the first electrode and the second electrode for a certain period of time, and in the second process, a process of maintaining a state in which 0 V is applied between the first electrode and the second electrode for a certain period of time.

In the above manufacturing method, in the first process, a positive voltage applied between the first electrode and the second electrode may be set to a different voltage value for each cycle.

In the above manufacturing method, in the first process, the positive voltage applied between the electrode and the second electrode is controlled by each process in order to prevent the value of the current flowing between the first electrode and the second electrode from exceeding the predetermined current value.

In the above manufacturing method, the positive voltage application time for applying the positive voltage in the first process is lengthened as the discharge capacity of the oxide semiconductor secondary battery increases.

In the above manufacturing method, the positive voltage application time for applying the positive voltage is the time until the voltage value of the oxide semiconductor secondary battery reaches the predetermined set voltage value.

Further, in the above manufacturing method, in addition to the first process and the second process, a third process for measuring the discharge capacity of the oxide semiconductor secondary battery is included, and a third process is executed after the predetermined number of the first unit cycles is repeated, the application of the voltage is terminated when it is measured that the discharge capacity of the oxide semiconductor secondary battery is not less than a predetermined threshold value.

In the manufacturing method, in addition to the first process and the second process, a third process for measuring a discharge capacity of the oxide semiconductor secondary battery and a fourth process for calculating an increase rate of the discharge capacity of the oxide semiconductor secondary battery at a predetermined time interval based on the discharge capacity measured in the third process, wherein after repeating the first unit cycle for a predetermined number of cycles, the third process and the fourth process is executed, and the application of the voltage is terminated when the increase rate of the discharge capacity is equal to or less than the predetermined threshold value.

In the manufacturing method described above, the intermediate insulating layer is formed by applying a silicone oil or a silicone oil to which a resistance adjusting agent is added is coated on the surface of the charging layer, then baking and irradiating with ultraviolet rays after baking to be cured by UV curing.

In the above manufacturing method, the intermediate insulating layer is formed on the charging layer by sputtering using silicon (Si) as a target.

In the above manufacturing method, the insulator of the intermediate insulating layer is SiOx (0≦x≦2).

In the above manufacturing method, the p-type metal oxide semiconductor is nickel oxide (NiO).

Furthermore, a method for manufacturing an oxide semiconductor secondary battery according to one embodiment of the present invention includes: a first electrode; an n-type metal oxide semiconductor layer formed of an n-type metal oxide semiconductor; and an n-type metal oxide semiconductor an intermediate insulating layer containing an insulator as a main component, a p-type metal oxide semiconductor layer made of a p-type metal oxide semiconductor, and a second electrode are stacked in this order, and then a second unit cycle is defined by a fifth process and a sixth process, wherein a fifth process of applying a positive voltage between the first electrode and the second electrode on the basis of the first electrode and a sixth process of applying a negative voltage between the first electrode and the second electrode on the basis of the first electrode, and a predetermined number of second unit cycles are repeated.

An oxide semiconductor secondary battery having a storage function according to the present invention is characterized by comprising a n-type metal oxide semiconductor layer, a charge composed of an n-type metal oxide and an insulator sandwiched between a conductive first electrode and a conductive second electrode layer. The oxide semiconductor secondary battery having this configuration is subjected to electrical treatment to form a layer containing an element of an insulating layer in a p-type metal oxide semiconductor between the intermediate insulating layer and the p-type metal oxide semiconductor layer (hereinafter referred to as a mixed layer), as a result, the discharge capacity can be increased.

The electrical treatment is processing of applying a positive voltage and applying 0 V or applying positive and negative electrodes to the second electrode side on the basis of the first electrode after formation of the secondary battery.

The fact that a new layer is formed at the interface between the p-type metal oxide semiconductor and the intermediate insulating layer by this electrical treatment is a result found experimentally. The new layer is a mixed layer in which a layer is formed as a micro interface by a substance diffused from the p-type metal oxide semiconductor and the intermediate insulating layer. It is considered that the accumulation capacity of positive charges (holes) increased due to the mixed layer which is a new layer, and the storage capacity increased. In addition, even in the charged layer formed by sintering the n-type metal oxide semiconductor and the insulating material by electric treatment, a change such as rearrangement of the material occurs, and the accumulation amount of the negative charge (electron) also increases conceivable. Therefore, for example, the result that the discharge capacity is doubled after the electrical treatment is obtained.

### Simple description of drawings

FIG. 1 shows a structure of an oxide semiconductor secondary battery manufactured by the present invention
FIG. 2 shows a structure of an oxide semiconductor secondary battery before and after application of a cycle voltage of positive and 0 V
FIG. 3 is a flowchart illustrating a process of manufacturing an oxide semiconductor secondary battery according to the present invention
FIG. 4 shows an example of an implementation of a cycle voltage application system
FIG. 5 shows an example of a voltage waveform of positive and 0 V
FIG. 6 shows an example of two-cycle voltage waveforms
FIG. 7 shows an example of a voltage waveform at the second electrode measured by a voltmeter with respect to the voltage waveform shown in FIG. 6 FIG. 8 is a flowchart illustrating a process for applying a voltage waveform
FIG. 9 is an example of a unit cycle in which the positive voltage shown in FIG. 5 is repeated.
FIG. 10 is a graph showing the relationship between the time and the discharge capacity when the positive voltage shown in FIG. 9 is repeatedly applied.
FIG. 11 shows an example of positive and negative voltage waveforms.
FIG. 12 shows another example of positive and negative voltage waveforms.
FIG. 13 is a graph showing the relationship between the time and the discharge capacity when the positive and negative voltages shown in FIG. 11 are repeatedly applied.
FIG. 14 is a diagram for explaining a conventional example.

### System for carrying out the invention

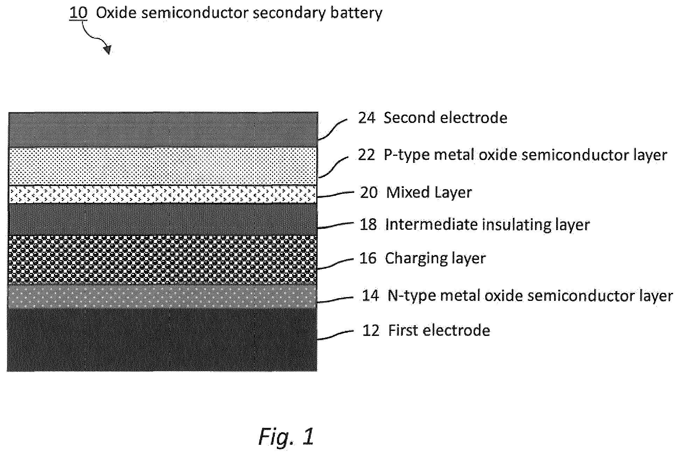

FIG. 1 shows the structure of an oxide semiconductor secondary battery 10 manufactured according to the present invention.

In Fig. 1, the oxide semiconductor secondary battery 10 includes a first electrode 12, an n-type metal oxide semiconductor layer 14, a charge layer 16, an intermediate insulating layer 18, a mixed layer 20, a p-type metal oxide semiconductor layer 22, and the second electrodes 24 are stacked in this order.

As the material of the first electrode 12, for example, a metal such as chromium (Cr) or titanium (Ti) can be used. In addition, as the other metal electrode of the first electrode 12, a silver (Ag) alloy film containing aluminum (Al) or the like can also be used. Further, the first electrode 12 may have a laminated structure in which a plurality of metal layers are laminated. The first electrode is required to be a material having a low resistivity. For example, it is preferable to use a material having a resistivity equal to or less than 100µΩ cm.

As the material of the first electrode 12, a metal foil such as copper, aluminum, stainless steel or the like can also be used as the substrate of the oxide semiconductor secondary battery 10.

As a material of the n-type metal oxide semiconductor layer 14, for example, an n-type metal oxide semiconductor such as titanium oxide (TiO₂), zinc oxide (ZnO), tin oxide (SnO₂) or the like can be used as a material. The n-type metal oxide semiconductor layer 14 is formed by forming an n-type metal oxide semiconductor on the first electrode 12.

The charge layer 16 is composed of an n-type metal oxide semiconductor and an insulator. As a material of the insulator, it is preferable to use a silicon compound (silicone) having a main skeleton by siloxane bonding such as silicon oxide. As the n-type metal oxide semiconductor of the charge layer 16, an n-type metal oxide semiconductor such as titanium oxide (TiO₂), zinc oxide (ZnO), tin oxide (SnO₂) or the like can be used. The n-type metal oxide semiconductor can be included in the insulator as nano-sized fine particles. Instead of the n-type metal oxide semiconductor, a precursor of an n-type metal oxide semiconductor, for example, titanium stearate which is a precursor of titanium oxide can be used.

The intermediate insulating layer 18 is configured to include an insulator or an insulator to which a resistance adjusting agent is added. As the material of the insulator, silicon oxide SiO₂, silicon nitride Si₃N₄, silicon oxide SiOₓ (0≦x≦2) and the like can be used.

The insulation resistance value of the intermediate insulating layer 18 can be adjusted by adding a resistance adjusting agent such as a metal, a metal oxide, a semiconductor material or the like to silicon oxide, silicon nitride or silicone oil. The fact that the insulation resistance value of the intermediate insulation layer 18, that is, the value of the current flowing through the intermediate insulation layer 18, affects the discharge capacity of the oxide semiconductor secondary battery 10 is experimentally clarified.

Therefore, it is necessary to adjust the discharge capacity of the oxide semiconductor secondary battery to an optimum value by adjusting the insulation resistance value of the intermediate insulating layer 18. For example, when the intermediate insulating layer 18 is formed with a thickness equal to or less than a predetermined value, it may be a layer containing silicon oxide as a main component. However, when the intermediate insulating layer 18 is formed with a predetermined thickness, that is, a thickness that is equal to or greater than the thickness at which the discharge capacity decreases, a resistance adjusting agent such as a metal or a semiconductor material is added to the silicon oxide, It is necessary to lower the insulation resistance value and to reduce the current flowing through the intermediate insulating layer 18 to a predetermined value or less. That is, the intermediate insulating layer 18 needs to be a layer including an insulator or an insulator to which a resistance adjusting agent is added. As the resistance adjusting agent, a metal, a metal oxide, a semiconductor material, or the like can be used.

The mixed layer 20 is a layer in which a p-type metal oxide semiconductor, a metal, and an insulator are mixed. The state of the mixed layer 20 is a state in which a p-type metal oxide semiconductor and an insulator are mixed, a state in which a metal element constituting a p-type metal oxide semiconductor is incorporated in an insulator, or a state in which a p-type metal oxide semiconductor, or in a state in which an element of an insulating material is incorporated into the insulating film.

The p-type metal oxide semiconductor layer 22 is composed of a p-type metal oxide semiconductor. As the material of the p-type metal oxide semiconductor, nickel oxide (NiO), copper aluminum oxide (CuAlO 2), or the like can be used.

As the material of the second electrode 24, chromium (Cr), copper (Cu) or the like can be used. As another material, a silver (Ag) alloy containing aluminum (Al) or the like can be used.

As the second electrode 24, a transparent conductive electrode can also be used. For example, a tin-doped indium tin oxide (ITO) is used as the second electrode 24) of conductive films can be used. It is necessary for the second electrode to be a material having a low resistivity, for example, it is preferable to use a material having a resistivity of 100 µΩ · cm or less.

The structure of the oxide semiconductor secondary battery 10 according to the present invention has been described above. In the following description, a method for electrically forming the mixed layer 20 will be described. In this method, after laminating the first electrode 12, the n-type metal oxide semiconductor layer 14, the charge layer 16, the intermediate insulating layer 18, the p-type metal oxide semiconductor layer 22 and the second electrode 24 in this order, The laminate is placed in an environment with humidity within 35 to 65 percent. Next, there is a method of repeatedly applying a positive voltage and 0 V of a cycle voltage from a voltage source between the first electrode 12 and the second electrode 24. and a method of repeatedly applying a positive voltage and a negative voltage of a cycle voltage from a voltage source. Hereinafter, a method for electrically forming the mixed layer will be described in detail.

### <Outline of Mixed Layer>

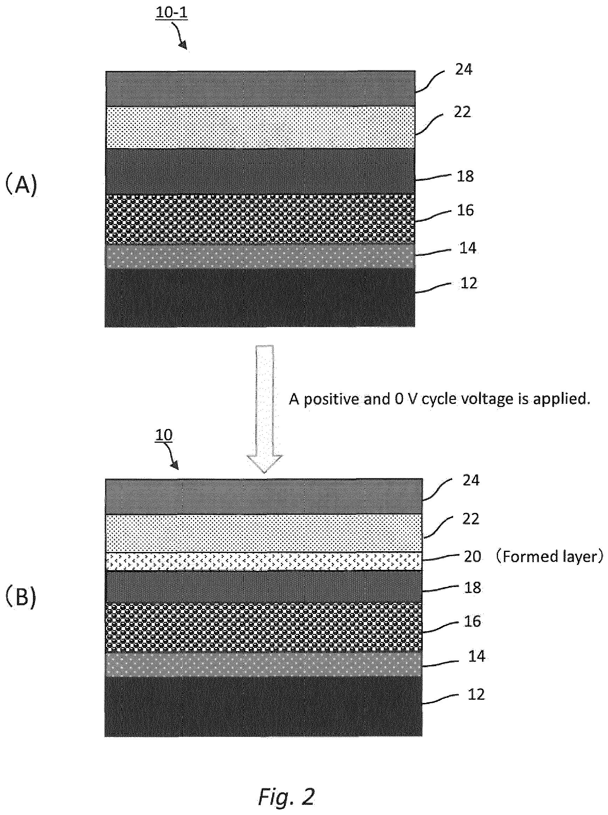

FIG. 2 shows a structure of an oxide semiconductor secondary battery 10 before and after application of a cycle voltage of positive and 0 V.

FIG. 2 (A) shows the structure of the oxide semiconductor secondary battery 10-1 in which the first electrode 12, the n-type metal oxide semiconductor layer 14, the charge layer 16, the intermediate insulating layer 18, the p-type metal oxide semiconductor layer 22 and the second electrode 24 are laminated in this order. That is, FIG. 2 (A) shows the oxide semiconductor secondary battery 10-1 before forming the mixed layer 20.

After forming the oxide semiconductor secondary battery 10-1 having the structure shown in FIG. 2A, a positive and 0 V cycle voltage is applied between the first electrode 12 and the second electrode 24 by a voltage source, and the mixed layer 20 is formed between the intermediate insulating layer 18 and the p-type metal oxide semiconductor layer 22. Thereby, the oxide semiconductor secondary battery 10 shown in FIG. 2 (B), in which the mixed layer 20 is formed, is manufactured. Formation of the mixed layer 20 by application of the cycle voltage is a layer found experimentally and the result that the discharge capacity is increased by formation of the mixed layer 20 is obtained.

### <Detailed Description of Mixed Layer>

Hereinafter, a method of manufacturing the oxide semiconductor secondary battery 10 including the mixed layer 20 will be described in detail using a flowchart.

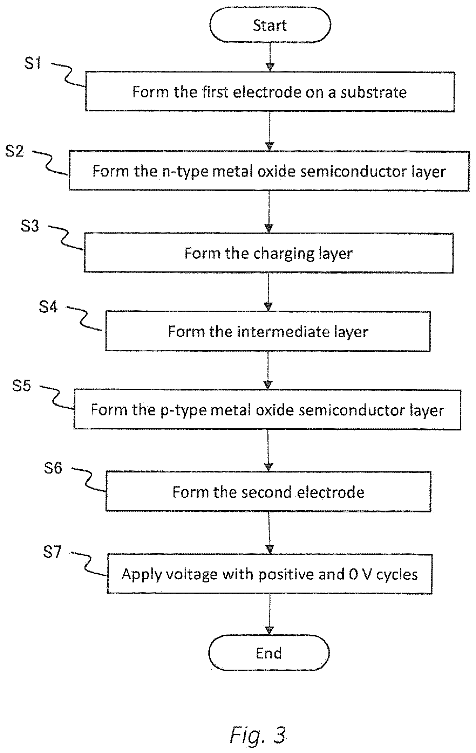

FIG. 3 is a flowchart for explaining the manufacturing process of the oxide semiconductor secondary battery according to the present invention.

In step S1, a first electrode 12 is formed on a substrate (not shown). In the case where a conductive metal foil is used as the substrate, the metal foil itself becomes the first electrode 12. For example, a metal foil such as copper, aluminum, stainless steel or the like can be used.

The first electrode 12 can also be formed by depositing a conductive metal such as chromium, titanium, or titanium nitride on an insulating substrate. As a material of the substrate, glass or a flexible resin sheet such as polyimide film can be used.

As a manufacturing method of the first electrode 12, a vapor phase film forming method such as sputtering, ion plating, electron beam vapor deposition, vacuum vapor deposition, chemical vapor deposition or the like can be mentioned. When the metal is used as the first electrode 12, it can be formed by electrolytic plating, electroless plating, or the like. In general, copper, copper alloy, nickel, aluminum, silver, gold, zinc, tin or the like can be used as the metal used for plating.

In step S2, the n-type metal oxide semiconductor layer 14 of a n-type metal oxide semiconductor film such as titanium oxide, tin oxide, zinc oxide or the like is formed on the first electrode 12.

In step S3, a charge layer 16 made of an n-type metal oxide semiconductor and an insulator is formed on the n-type metal oxide semiconductor layer 14.
The charging layer (16) is a mixture of a precursor of an n-type metal oxide semiconductor such as tin oxide or zinc oxide, silicone oil as an insulator and a solvent, and is formed by a spin coating method, a slit coating method, a spin coating method, a spin coating method, a spin coating method, or a slit coating method, and then drying and firing, the n-type metal oxide semiconductor layer 14. is spin-coated, the n-type metal oxide semiconductor layer 14 is coated on the n-type metal oxide semiconductor layer 14 by a slit coating method or the like, drying and baking. As the precursor, for example, titanium stearate which is a precursor of titanium oxide can be used. Titanium oxide, tin oxide and zinc oxide are formed by decomposition from an aliphatic acid salt which is a metal precursor. Upon drying and firing, the charging layer 16 may be irradiated with ultraviolet rays and UV-cured.

Incidentally, there is also a method of using these nanoparticles instead of forming titanium oxide, tin oxide, zinc oxide or the like from the metal precursor. Nanoparticles of titanium oxide, tin oxide, zinc oxide or the like are mixed with silicone oil, and the viscosity is adjusted by mixing the solvent. The charging layer 16 is formed by a spin coating method, a slit coating method, or the like, followed by drying, baking and UV irradiation.

In step S4, the intermediate insulating layer 18 containing an insulator as a main component is formed on the charging layer 16. The intermediate insulating layer 18 is formed by depositing silicon oxide, silicon nitride, or the like on the charge layer 16 by sputter deposition, plasma enhanced chemical vapor deposition (PECVD), or the like. Further, it can be formed on the charge layer 16 by sputtering using silicon as a target. Alternatively, it may be formed by applying silicone oil on the charge layer 16, and thereafter baking the silicone oil. Ultraviolet rays may be irradiated to the silicone oil after baking and UV curing may be carried out.

In order to set the current value flowing through the intermediate insulating layer 18 to a predetermined value, the layer thickness of the intermediate insulating layer 18 and the amount and kind of the resistance adjusting agent added to the insulating material are changed, and the insulating resistance value of the intermediate insulating layer 18 is adjusted. The resistance adjusting agent may be, for example, a metal or an n-type semiconductor. Examples of the n-type semiconductor include a material obtained by adding a small amount of phosphorus as an impurity to silicon to form an n-type semiconductor, titanium oxide, zinc oxide, and the like.

In step S5, the p-type metal oxide semiconductor layer 22 is formed on the intermediate insulating layer 18. As a material of the p-type oxide semiconductor, nickel oxide (NiO) or the like can be used.

In step S6, the second electrode 24 is formed on the p-type metal oxide semiconductor layer 22. A second electrode 24 is formed on the p-type metal oxide semiconductor layer 22 by a sputtering deposition method by stacking aluminum, palladium, titanium nitride, aluminum, and titanium nitride. The method of forming the second electrode 24 is not limited to the sputter deposition method, and a thin film forming method such as an evaporation method, an ion plating method, a MBE (Molecular Beam Epitaxy) method, or the like may be used. Further, the second electrode 24 may be formed using a coating forming method such as a printing method or a spin coating method.

In step S7, a cycle voltage of positive and 0 V is repeatedly applied to the oxide semiconductor secondary battery 10 manufactured in step S1 to step S 6, and then a new layer is formed between the intermediate insulating layer 18 and the p-type metal oxide semiconductor layer 22. This new layer is the mixed layer 20.

By repeatedly applying a positive and 0 V cycle voltage to the oxide semiconductor secondary battery 10, a microscopic interface is formed between the intermediate insulating layer 18 and the metal oxide semiconductor layer 22 by the p-type metal oxide semiconductor diffused from the p-type metal oxide semiconductor layer 22 and the substance diffused from the insulator of the intermediate insulating layer 18. This interface layer is the mixed layer 20.

The result that the discharge capacity of the oxide semiconductor secondary battery 10 increases by repeatedly applying the positive and 0 V cycle voltage is obtained. Because the existence of the mixed layer 20 increases the storage capacity of positive charges (holes), and the rearrangement of the titanium oxide and the insulating material in the charge layer 16 increases the storage capacity of the negative charge (electron). The cycle voltage may be positive and negative voltages.

Next, a cycle voltage application system that applies a positive and 0 V cycle voltage to the oxide semiconductor secondary battery 10 and an example of a positive and 0 V cycle voltage waveform will be described.

### <Voltage Application System>

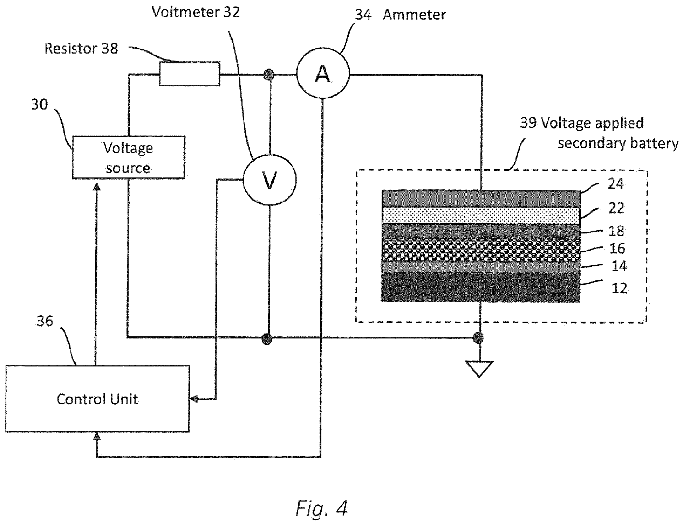

FIG. 4 shows an example of an implementation circuit of the cycle voltage application system.

The cycle voltage application system includes a voltage source 30, a voltmeter 32, an ammeter 34, a controller 36, and a resistor 38. The voltage source 30 is connected between the first electrode 12 and the second electrode 24 of the voltage-applied secondary battery 39. The voltmeter 32 and the ammeter 34 are connected between the voltage source 30 and the voltage-applied secondary battery 39. Further, a resistor 38 is connected between the voltage source 30 and the voltage-applied secondary battery 39. The voltage-applied secondary battery 39 is, for example, the oxide semiconductor secondary battery 10 having the structure shown in FIG. 2 (A).

The control unit36 is connected to a voltage source 30, a voltmeter 32, and an ammeter 34. The control device 36 controls the voltage source 30. The first unit cycle has a first process of applying a positive voltage between the first electrode and the second electrode with the first electrode 12 as a reference (ground) and a second process of applying 0 V between the first electrode and the second electrode, the first process and the second process are applied in this order. A predetermined number of first unit cycles are applied repeatedly by thee control device 36.

A positive voltage value to be applied in the first process, an application time (hereinafter abbreviated as "unit cycle information") for applying positive and 0 V cycle voltage in the first process and the second process, and a cycle number are stored in the control unit 36 as cycle information. The control device 36 controls the voltage source 30 based on the stored cycle information.

The voltage source 30 applies a positive and 0 V cycle voltage between the first electrode 12 and the second electrode 24 via a resistor 38 based on a control signal from the control unit 36.

Next, a method of applying a positive and 0 V cycle voltage to the voltage-applied secondary battery 39 will be described.

The positive voltage output from the voltage source 30 is applied to the secondary battery 39 via the resistor 38. The voltage-applied secondary battery 39 is substantially the same as the oxide semiconductor secondary battery 10 - 1 without the mixed layer 20 shown in FIG. 2 (A). To the voltage-applied secondary battery 39, the first electrode 12 is grounded (that is, the first electrode 12 is 0 V), the output voltage from the voltage source 30 is applied to the second electrode 24 with reference to the first electrode 12.

To the control unit 36, a voltmeter 32 and an ammeter 34 are connected. The voltage value measured by the voltmeter 32 and the current value measured by the ammeter 34 are fed back to the control unit 36. The control device 36 controls the voltage source 30 based on the fed back voltage value, the current value, and the previously stored cycle information, thereby controlling the positive and 0 V cycle voltages output from the voltage source 30.

Since the voltage from the voltage source 30 is being applied to the voltage-applied secondary battery 39 via the resistor 38, the voltage output from the voltmeter 32 is a charge voltage charged in the voltage-applied secondary battery 39 .

In order to prevent generation of excessive current due to voltage change and increase in discharging capacity of the voltage-applied secondary battery 39, the voltage source 30 has a current limiting function for limiting the maximum current to a predetermined current. The voltage source 30 can also control the voltage output to the voltage-applied secondary battery 39 independently from the control unit 36.

Next, an example of a voltage waveform applied to the voltage-applied secondary battery 39 is shown.

### <Example of Voltage Waveform>

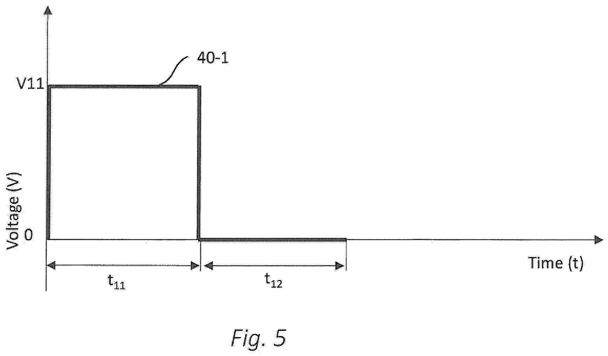

FIG. 5 shows an example of a voltage waveform 40 -1 of positive and 0 V.

This unit cycle is the voltage waveform 40 -1 that applies the positive voltage V₁₁ to the voltage-applied secondary battery 39 for the application time tn and 0 V for the application time t₁₂. By repeating this unit cycle by a predetermined number of times, the mixed layer 20 can be formed between the intermediate insulating layer 18 and the p-type metal oxide semiconductor layer 22. The mixed layer 20 thus formed can increase the discharge capacity of the voltage-applied secondary battery 39 with respect to the initial discharge capacity. Here, the initial discharge capacity is the discharge capacity before the application of the cycle voltage of positive and 0 V or the positive and negative cycle voltage to the voltage-applied secondary battery 39. Although illustration is omitted, it is also possible to set the cycle voltage to apply the positive voltage after applying 0 V, with the order of applying the voltage reversed, as a unit cycle.

In the case where the first electrode 12 is grounded, it is preferable that the value of the positive voltage applied to the second electrode 24 includes at least a value equal to or higher than the charging voltage of the voltage-applied secondary battery 39.

In the voltage waveform 40-1, the positive voltage Vn is held for the positive voltage application time t₁₁, but the positive voltage application time tn for applying the positive voltage V₁₁ can also be set long as the discharge capacity of 39 increases. By increasing the positive voltage application time t₁₂ for applying the positive voltage V₁₁ as the discharge capacity increases, sufficient charging can be performed and the thickness of the mixed layer 20 can be efficiently increased.

Further, the positive voltage application time t₁₂ to which the positive voltage V₁₁ is applied can be set to a time until the voltage value of the voltage-applied secondary battery 39 reaches a predetermined set voltage value. This set voltage value is set equal to or lower than the charging voltage of the voltage-applied secondary battery 39 or higher than the charging voltage of the voltage-applied secondary battery 39, thereby efficiently forming the mixed layer 20. Combinations of this set voltage can be experimentally obtained.

When the positive voltage V₁₁ is set to be equal to or lower than the charging voltage of the voltage-applied secondary battery 39, damage to the voltage-applied secondary battery 39 can be minimized. Further, the set voltage value can be set to be equal to or higher than the charging voltage of the voltage-applied secondary battery 39. In this case, it is possible to shorten the time until the mixed layer 20 having a desired thickness is formed. Therefore, by setting the set voltage value to be equal to or lower than the charge voltage of the voltage-applied secondary battery 39 or setting it to be equal to or higher than the charge voltage of the voltage-applied secondary battery 39, the voltage-applied secondary battery 39 is not damaged, the time can be shortened, and the mixed layer 20 can be efficiently formed.

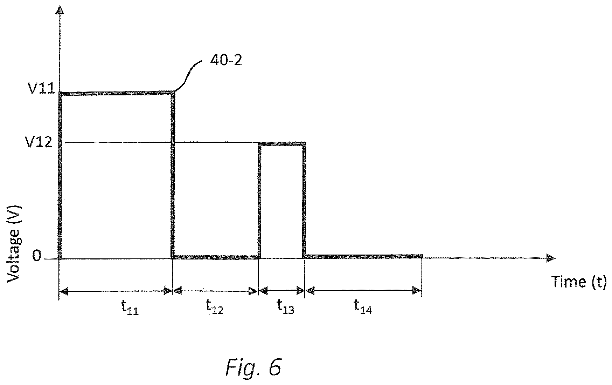

FIG. 6 shows an example of a two-cycle voltage waveform 40 -2 obtained by combining unit cycles of different positive voltages.

In this unit cycle information, a voltage waveform 40-2 to the voltage-applied secondary battery 39 is included. The voltage waveform 40-2 is composed of a unit cycle in which the positive voltage V₁₁ is applied for the application time t₁₁ and 0 V is applied for the application time t₁₂, and a unit cycle in which the voltage V₁₂ is applied for the application time t₁₃ and 0 V is applied for the application time t₁₄. That is, every time the unit cycle is repeated, the value of the positive voltage, the time of applying the positive voltage, and the time of applying 0 V are different. The mixed layer 20 can be efficiently formed by the voltage waveform 40 -2 according to such a unit cycle, and the discharge capacity of the voltage-applied secondary battery 39 can be increased with respect to the initial discharge capacity. Even if the positive voltage and its application time are different in all unit cycles or plural kinds of pairs of positive voltage and positive voltage are prepared and at least two kinds of pairs are used in the whole stroke, the discharge capacity of the voltage application secondary battery 39 can be increased with respect to the initial discharge capacity. Although not shown in the figure, it is also possible to adopt a cycle voltage in which the order of applying voltages is reversed, a unit cycle of applying 0 V and then applying a positive voltage is repeated 2 cycles. In this case, different positive voltages may be set for each cycle.

Here, the application time t₁₁ and the application time t₁₃ for applying the positive voltage may be any time as long as it holds a state in which the positive voltage is applied to the voltage-applied secondary battery 39 for a certain time. In addition, the application time t 12 and the application time t 14 for applying 0 V may be any time as long as the electric charge charged in the voltage-applied secondary battery 39 can be discharged.

In the voltage waveform 40 -2, a constant positive voltage V₁₁ is applied to the voltage-applied secondary battery 39 for an application time t₁₁ and a constant positive voltage V₁₂ is applied for an application time t₁₃, The application time t₁₁ and the application time t₁₃ may be changed for each cycle.

In order to prevent the value of the current flowing between the first electrode 12 and the second electrode 24 from exceeding the predetermined current value, the voltage applied between the first electrode 12 and the second electrode 24 Can be controlled by each process of applying unit cycles. It is possible to prevent an excessive current from being applied to the voltage-applied secondary battery 39 by controlling the current so as not to exceed the current value predetermined in each process.

The positive voltage application time for applying the positive voltage can be lengthened as the discharge capacity of the voltage-applied secondary battery 39 increases. As the discharge capacity increases, the thickness of the mixed layer 20 can be increased efficiently by lengthening the positive voltage application time for applying the positive voltage.

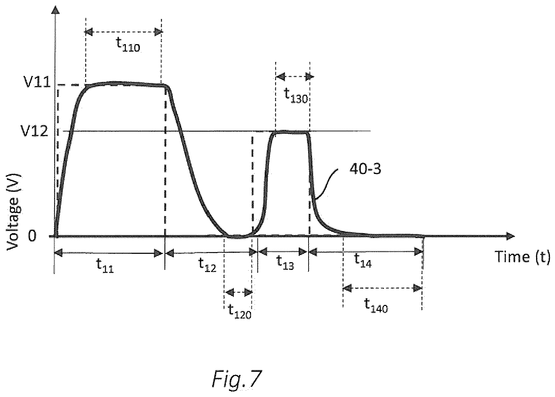

FIG. 7 shows a voltage waveform example 40 - 3 at the second electrode 24 actually measured by the voltmeter 32 with respect to the voltage waveform 40 - 2 shown in FIG. 6.

The voltage source 30 limits the value of the current to be output independently of the control of the control device 36 for the purpose of preventing abrupt current change. Therefore, the voltage value of the second electrode 24 approaches the positive voltage V₁₁ gradually.

For example, when switching from the positive voltage V₁₁ to 0 V, there is a large voltage change and discharge is abruptly performed to the voltage-applied secondary battery 39, so the current limitation by the voltage source 30 works. This current limitation limits the discharge of the charged charge.

The cumulative time of the positive voltage holding times t₁₁₀, t₁₃₀ and 0V holding times t₁₂₀, t₁₄₀ is required to be longer than a certain time in order to form a new layer. If the cumulative time of the positive charge holding time and the 0 V holding time is small, a new layer cannot be formed. Therefore, after repeating a predetermined number of positive and 0 V cycle voltages between the first electrode 12 and the second electrode 24, a process of measuring the discharge capacity of the voltage-applied secondary battery 39 is executed. When it is measured that the discharged capacity of the voltage-applied secondary battery 39 is equal to or higher than a certain threshold value, the repetition of the cycle voltage of positive and 0 V is terminated. As a result, while securing a sufficient cumulative time of positive voltage holding times t₁₁₀, t₁₃₀, 0V holding time t₁₂₀, t₁₄₀, it is possible to form the mixed layer 20 having a desired thickness on the interface between the intermediate insulating layer 18 and the p-type metal oxide semiconductor layer 22 in the voltage-applied secondary battery 39.

In addition to the process of measuring the discharge capacity of the voltage-applied secondary battery 39, the rate of increase in the discharge capacity of the voltage-applied secondary battery 39 can be calculated at predetermined time intervals based on the measured discharge capacity. When the increase rate of the discharge capacity is equal to or less than the predetermined threshold value, the application of the positive and 0 V cycle voltage is terminated, thereby ending the application of the unnecessary voltage to the voltage application secondary battery 39. The voltage-applied secondary battery 39 in which the discharge capacity does not increase can also be classified as a defective product or a low-grade secondary battery.

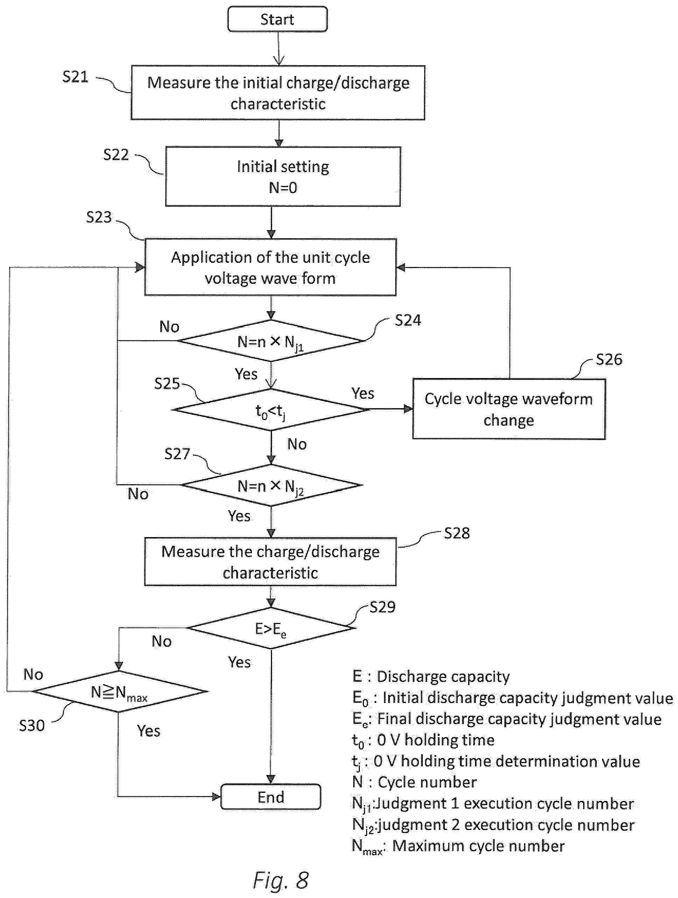

FIG. 8 is a flowchart illustrating a process of applying a voltage waveform.

First, in step S21, the charge/discharge characteristic of the voltage-applied secondary battery 39 is measured before applying the cycle voltage to obtain the initial discharge capacity judgment value E0.

For example, in the charge/discharge characteristics, a positive voltage V₁ with reference to the first electrode 12 is applied to the second electrode 24 at a constant voltage to charge the voltage-applied secondary battery 39, and thereafter, the voltage is changed to 0 V in real time, and continuously discharged until the voltage value to be measured falls below the threshold value. The initial discharge capacity judgment value E0 is obtained by the total energy amount at the time of discharge calculated from the charge capacity of the voltage-applied secondary battery 39 and the discharge time and the like. Further, when the obtained initial discharge capacity judgment value E 0 is smaller than the specified value, it can be determined that the voltage-applied secondary battery 39 is defective.

In step S22, initial setting is performed. Here, the applied voltage and the application time (that is, the cycle information stored in the control device 36 in the initial stage) are set.

In order to regularly determine the time (hereinafter referred to as "0 V holding time" (t₁₂ in FIG. 5) during which the voltage of the second electrode 24 of the voltage-applied secondary battery 39 is maintained at the set 0 V, the determination 1 cycle set number Nⱼ₁. This is set to check periodically whether the voltage on the side of the second electrode 24 is maintained at 0 V for a certain time or more.

The 0 V holding time determination value tj is a reference time used for comparison with the 0 V holding time to. The judgment 1 execution cycle number Nⱼ₁ is the number of cycles to be a reference for changing the voltage waveform when the number of cycles N is executed the number of times specified by the judgment 1 execution cycle number Nⱼ₁ and the 0 V holding time to does not reach the negative voltage holding time judgment value tj.

The final discharge capacity judgment value Eₑ is set to judge whether a sufficient discharge capacity has been obtained. The judgment 2 execution cycle number Nⱼ₂ is the number of cycles for measuring charge and discharge and confirming discharge capacity. When the discharge capacity reaches the final discharge capacity judgment value Ee, the voltage application cycle ends.

Even if the number of cycles is equal to or greater than a certain value, when the discharge capacity can not be sufficiently obtained, the maximum cycle number Nₘₐₓ is also set in order to end the voltage application cycle. When the discharge capacity does not reach the final discharge capacity judgment value Ee even when the maximum cycle number Nₘₐₓ is reached, the voltage-applied secondary battery 39 can be handled as a defective product.

In step S23, the voltage waveform set in the unit cycle is applied to the voltage-applied secondary battery 39, and 1 is added to the cycle number N. In step S24, it is determined whether or not the cycle number N is an integer multiple (n × Nⱼ₁, n = 1, 2, 3...) of the judgment 1 execution cycle number Nⱼ₁. If the cycle number N is not an integer multiple (n × Nⱼ₁, n = 1, 2, 3...) of the judgment 1 execution cycle number Nⱼ₁, the unit cycle voltage is applied again. If the number of cycles N is equal to an integral multiple of the judgment 1 execution cycle number Nⱼ₁, the 0 V holding time t₀ is judged in step S25.

If the 0 V hold time t₀ is smaller than the reference 0 V hold time determination value tⱼ, the voltage waveform is changed in step S 26 and the process returns to step S23 to apply the changed voltage waveform.

If the 0 V holding time t₀ is greater than the reference 0 V holding time determination value tⱼ, the cycle number N is an integer multiple of the judgment 2 execution cycle number Nⱼ₂ (n × Nⱼ₂, n = 1, 2, 3 ...) in step S27. If the cycle number N is not equal to the multiple of the judgment 2 execution cycle number Nⱼ₂, the process returns to step S 23 and the unit cycle voltage is applied. When the cycle number N is equal to the integer multiple of the judgment 2 execution cycle number Nⱼ₂, charge/discharge characteristics are measured in step S29.

In step S29, the discharge capacity E is obtained from the measured charge/ discharge characteristics and is compared with the reference final discharge capacity judging value Ee. When the discharge capacity E is equal to or more than the final discharge capacity determination value Ee, the application of the voltage is terminated. At this time, the mixed layer 20 is formed as a new in the oxide semiconductor secondary battery 10.

If the discharge capacity E is smaller than the final discharge capacity determination value Ee, the number N of cycles is compared with the maximum cycle number Nₘₐₓ in step S30, and if the cycle number N is less than the maximum cycle number Nₘₐₓ, the process returns to step S23, and a voltage waveform is applied. If the number of cycles N is equal to or greater than the maximum cycle number Nₘₐₓ, the application of the voltage is terminated, and the performance of the voltage-applied secondary battery 39 cannot reach the target and is treated as a defective product.

A method of electrically forming the mixed layer 20 between the intermediate insulating layer 18 and the p-type metal oxide semiconductor layer 22 in the oxide semiconductor secondary battery 10 has been described above.

Next, a method of manufacturing the oxide semiconductor secondary battery 10 according to the present invention will be specifically described.

### <Manufacturing Method>

In manufacturing the oxide semiconductor secondary battery 10, glass which is an insulating substance was used as a substrate. First, the first electrode 12 was formed with a film thickness of 100 to 300 nm by using a sputter deposition method with chromium as a target. As a manufacturing apparatus, an RF sputtering apparatus was used. It is preferable that the first electrode 12 be made of a material having a resistivity of, for example, 100 µΩ · cm or less in order to make it easy for a current to flow.

Thereafter, in the n-type metal oxide semiconductor layer 14 laminated on the first electrode 12, titanium oxide was deposited by a sputter deposition method. The film thickness of the n-type metal oxide semiconductor layer 14 was 50 nm to 200 nm.

As a method for manufacturing the charge layer 16, firstly, a mixed solution of a fatty acid titanium and a silicone oil was coated on the formed n-type metal oxide semiconductor layer. Coating was carried out by a spin coating method in which the mixed solution was dropped while rotating a glass substrate on which the first electrode 12 and the n-type metal oxide semiconductor layer were laminated by spin coating. The thickness of the formed coating film is about 2 µm.

Further, the coated film was dried at 50° C. for about 10 minutes and then baked at 300°C to 400°C for 10 minutes to 1 hour. Subsequently, the coating film after baking was irradiated with ultraviolet rays using a UV irradiation apparatus to cure the silicone oil.

Next, in the intermediate insulating layer 18 made of an insulating material, a thin film of silicon oxide was deposited by a sputter deposition method using a silicon as a target. The insulation resistance value of the intermediate insulating layer 18 is control by a thickness. The thickness of the intermediate insulating layer 18 is 10 to 100 nm

Furthermore, in the p-type metal oxide semiconductor layer 22 made of a p-type metal oxide semiconductor, a nickel oxide film was formed by a sputter deposition method. For example, a nickel oxide film having a thickness of 120 to 300 nm is formed as a p-type metal oxide semiconductor layer 22. The method for forming the p-type metal oxide semiconductor layer 22 is not limited to the sputter deposition method, and a thin film forming method such as an evaporation method, an ion plating method, an MBE method, or the like can be used.

The second electrode 24 is formed by sputtering deposition method using aluminum as a material, and an aluminum thin film having a thickness of 100 to 300 nm, for example, is formed.

Next, a cycle voltage of positive and 0 V is repeatedly applied between the first electrode 12 and the second electrode 24 by a cycle voltage applying system. Thereby, the mixed layer 20 is formed, and the oxide semiconductor secondary battery 10 in the final structure is manufactured.

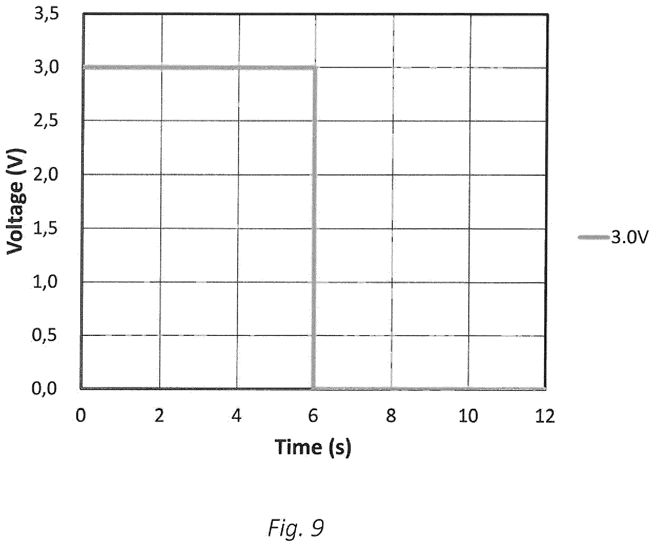

FIG. 9 shows an example of the voltage waveform of the actually applied unit cycle. The applied positive voltage is 3.0 V. Each positive voltage was applied for 6 seconds, then 6 seconds 0 V was applied for 6 seconds. That is, the unit cycle is a positive voltage pulse waveform. The application time is 12 seconds and the duty is 50%.

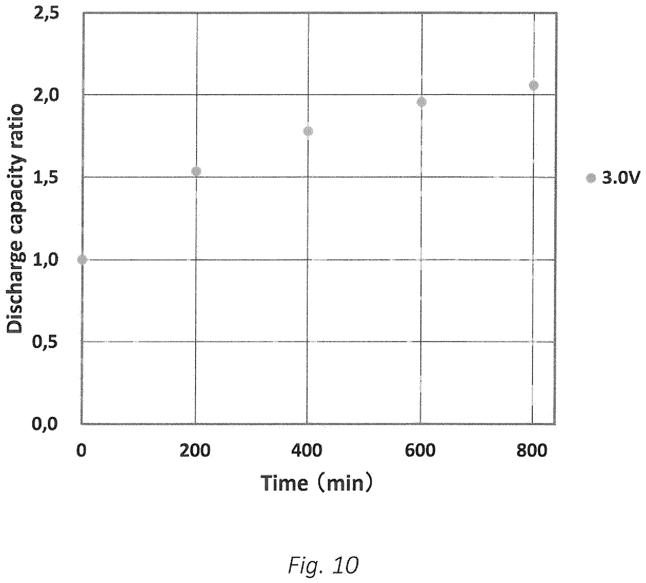

FIG. 10 shows the time when a unit cycle with a positive voltage of 3.0 V was applied and the discharge capacity ratio with respect to the initial discharge capacity. The unit of time is minutes, and five unit cycles are applied per minute.

Assuming that the positive voltage is 3.0 V, the discharge capacity ratio further increases with the increase of the time for applying the unit cycle. The discharge capacity ratio is 1.53 at 400 minutes when the number of cycles of the applied unit cycle becomes 2,000, and the discharge capacity ratio reached 2.06 at 800 minutes when the number of cycles of the applied unit cycle reached 4,000 times. This is because the formation of the mixed layer 20 is also accelerated by raising the positive voltage.

When the positive voltage is overvoltage, the discharge capacity decreased, because it seems that the damage to the voltage-applied secondary battery 39 occurred.

Damage to the voltage-applied secondary battery 39 depends on the relationship between the voltage value and the application time. In case of overvoltage, it can deal with by shortening the application time. This suggests the possibility of shortening the formation time of the mixed layer 20. Further, the formation time of the mixed layer 20 can be made shorter by the combination of the negative voltage.

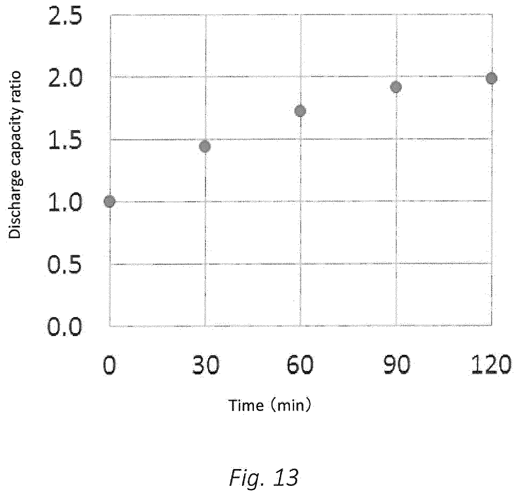

The discharge capacity ratio shown in FIG. 10 is an example. For example, by optimizing the cycle of the unit cycle and the waveform of the positive voltage, it is possible to shorten the time at which the discharge capacity ratio increases. For example, the time at which the discharge capacity ratio is 2.0 or more is about 800 minutes, but as shown in FIG. 13 to be described later, the time for which the discharge capacity ratio becomes 2.0 or more can be shortened to 120 minutes.

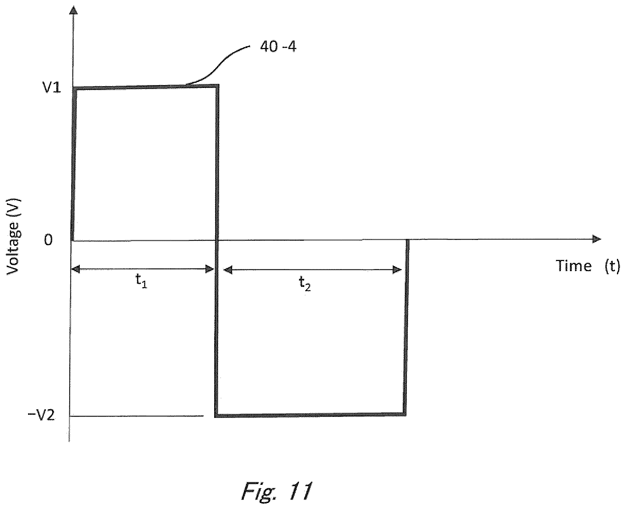

FIG. 11 shows an example of a voltage waveform 40-4 of a unit cycle combining a positive voltage and a negative voltage.

In the voltage waveform 40-4, as a first process, a positive voltage V1 is firstly applied to the voltage-applied secondary battery 39 for the application time t₁ and then a negative voltage V2 is applied for the application time t₂. Even when such positive and negative cycle voltages are applied to the voltage-applied secondary battery 39, the mixed layer 20 can be formed between the intermediate insulating layer 18 and the p-type metal oxide semiconductor layer 22. Although a figure is not shown, it is also possible to adopt a cycle voltage in which the order of applying voltages is reversed and a positive voltage is applied after negative voltage is applied.

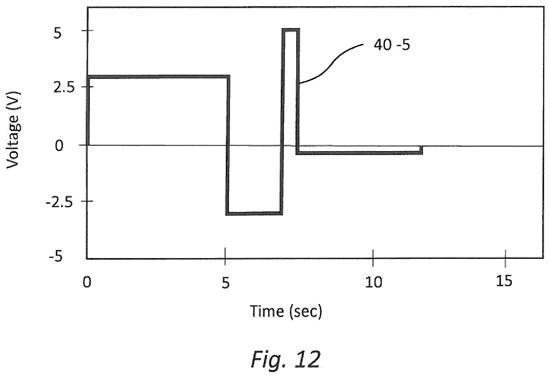

FIG. 12 shows a voltage waveform example 40-5 in a unit cycle using a positive voltage and a negative voltage cycle voltage. This unit cycle is a voltage waveform that applies two cycles of positive and negative voltages different in applied voltage and application time.

First, a positive voltage of 3V is applied for 5 seconds and then a negative voltage of -3 V is applied for 2 seconds. After applying a positive voltage of 5 V for 0.5 second, a negative voltage of -1V is applied for 4.5 seconds. The unit cycle time is 12 seconds in total. The charging voltage of the fabricated oxide semiconductor secondary battery is 2.2 to 2.3 V, and the positive voltage is applied with a voltage higher than the charging voltage at the time of two application. The absolute value of the negative voltage in the first cycle is higher than the charging voltage. The positive voltage of 5 V at the second cycle is applied for 0.5 second in order to shorten the formation time of the mixed layer 20 by applying a high voltage for a short time. In addition, the current limit value was 20 mA/ cm² in both plus and minus directions.

The positive and negative voltages in this unit cycle were repeatedly applied to the oxide semiconductor secondary battery 10. Although the figure is not shown, it is also possible to adopt a cycle voltage in which the order of applying voltages is reversed and a unit cycle in which a positive voltage is applied after applying a negative voltage is repeated two cycles. In this case, different positive and negative voltages may be set for each cycle.

FIG. 13 shows the relationship between the time and the discharge capacity when the positive and negative voltages shown in FIG. 12 are repeatedly applied. Since the unit cycle time is 12 seconds, the number of cycles per yime is the same as in the case of FIG. 10.

The discharge capacity is measured every 30 minutes and is expressed as a ratio to the initial discharge capacity. The discharge capacity is about 1.5 times the initial discharge capacity after 30 minutes, and two times after 120 minutes.
When the positive voltage shown in FIG. 10 was 3.0 V, the time for which the discharge capacity doubled was 800 minutes, whereas the time for which the discharge capacity was 120 minutes by voltage waveform of example 40-5. Significant time reduction has been realized. Further, by appropriately deforming the voltage waveform based on the experimental data, the formation time of the mixed layer 20 can be further shortened.

In the case where a cycle voltage of positive and 0 V and a positive and negative cycle voltage are applied to the voltage-applied secondary battery 39 in a state where the voltage-applied secondary battery 39 is disposed under a predetermined humidity environment, it is possible to further increase the discharge capacity of the voltage-applied secondary battery 39 with respect to the initial discharge capacity. The humidity is preferably, for example, 35 to 65 percent.

In addition, a positive voltage and a cycle voltage of 0 V can be applied to the oxide semiconductor secondary battery 10 used for a certain period, or a cycle voltage of a positive voltage and a negative voltage can be applied. This makes it possible to regenerate the discharge capacity of the oxide semiconductor secondary battery 10 that has been reduced by use to a predetermined value.

Although the embodiments of the present invention have been described above, the present invention includes appropriate modifications that do not impair the objects and advantages thereof, and furthermore, the present invention is not limited by the above embodiments.

10, 10 -1: oxide semiconductor secondary battery
12: First electrode
14: N-type metal oxide semiconductor layer
1.6: Charging layer
18: Intermediate insulating layer
22: P-type metal oxide semiconductor layer
24: Second electrode
30 : Voltage source
32: Voltmeter
34: Ammeter
36: Controller
38: Resistor
39: Voltage applied secondary battery
40, 40 - 1, 40 - 2, 40 - 3, 40 - 4, 40 - 5: Voltage waveform

## Claims

1. A method for manufacturing an oxide semiconductor secondary battery, the method comprising:
a first electrode,
a n-type metal oxide semiconductor layer made of n-type metal oxide semiconductor,
a charging layer made of n-type metal oxide semiconductor and the insulator,
a intermediate insulating layer mainly composed of an insulator,
a p-type metal oxide semiconductor layer made of a-type metal oxide semiconductor, and
a second electrode,
are laminated in this order, and then
a predetermined number of a first unit cycle comprising by a first process and a second process is applied between the first electrode and the second electrode repeatedly,
wherein,
the first process in which the first electrode is grounded and a positive voyage is applied between the first electrode and the second electrode, and
the second process in which the first electrode is grounded and 0 V is applied between the first electrode and the second electrode.

2. The method for manufacturing the oxide semiconductor secondary battery according to claim 1,
wherein in the case where the first electrode is grounded, the value of the positive voltage applied to the second electrode in the first process includes a value that is at least equal to or higher than the charging voltage of the oxide semiconductor secondary battery.

3. The method for manufacturing the oxide semiconductor secondary battery according to claim 1,
wherein the first process includes a process of holding a state in which a positive voltage is applied between the first electrode and the second electrode for a certain period of time, and
the second process includes a process in which 0V is applied between the first electrode and the second electrode for a certain period of time.

4. The method for manufacturing the oxide semiconductor secondary battery according to claim 3,
wherein in the first process, a positive voltage applied between the first electrode and the second electrode is set to a different voltage value for each cycle.

5. The method for manufacturing the oxide semiconductor secondary battery according to claim 1,
wherein in the first process, the value of the current flowing between the first electrode and the second electrode is controlled so that the value of the current flowing between the first electrode and the second electrode does not exceed the current value predetermined in the first process.

6. The method for manufacturing the oxide semiconductor secondary battery according to claim 1,
wherein the positive voltage application time for applying the positive voltage is lengthened as the discharge capacity of the oxide semiconductor secondary battery increases

7. The method for manufacturing the oxide semiconductor secondary battery according to claim 1,
wherein the positive voltage application time for applying the positive voltage is a time until the voltage value of the oxide semiconductor secondary battery reaches a predetermined set voltage value.

8. The method for manufacturing the oxide semiconductor secondary battery according to claim 1,
wherein a third process of measuring a discharge capacity of the oxide semiconductor secondary battery is provided in addition to the first process and the second process, and
executing the third process after repeating the first unit cycle by a predetermined number of cycles, and
the application of the voltage is terminated when it is measured that the discharge capacity of the oxide semiconductor secondary battery is equal to or higher than a predetermined threshold value.

9. The method for manufacturing the oxide semiconductor secondary battery according to claim 1,
wherein the third process of measuring the discharge capacity of the oxide semiconductor secondary battery and a fourth process for calculating the increase rate of the discharge capacity of the semiconductor secondary battery at predetermined time intervals based on the discharge capacity measured in the third process are provided in addition to the first process and the second process,
the third process and the fourth process are executed after repeating a predetermined number of the unit cycles, and
the application of the voltage is terminated when the rate of increase of the discharge capacity is less than a predetermined threshold value.

10. The method for manufacturing the oxide semiconductor secondary battery according to claim 1,
wherein the intermediate insulating layer is formed by applying silicone oil or silicone oil to which the resistance adjusting agent is added on the surface of the charging layer, and then by firing and irradiating with ultraviolet light after firing to UV curing.

11. The method for manufacturing the oxide semiconductor secondary battery according to claim 1,
wherein the intermediate insulating layer is formed on the charge layer by sputtering using silicon (Si) as a target.

12. The method for manufacturing the oxide semiconductor secondary battery according to claim 1,
wherein the insulator of the intermediate insulating layer is SiOₓ (0≦x≦2).

13. The method for manufacturing the oxide semiconductor secondary battery according to claim 1,
wherein the p-type metal oxide semiconductor is nickel oxide (NiO).

14. A method for manufacturing an oxide semiconductor secondary battery, the method comprising:
a first electrode,
a n-type metal oxide semiconductor layer made of n-type metal oxide semiconductor,
a charging layer made of n-type metal oxide semiconductor and the insulator,
a intermediate insulating layer mainly composed of an insulator,
a p-type metal oxide semiconductor layer made of a-type metal oxide semiconductor, and
a second electrode,
are laminated in this order, and then
a predetermined number of a second unit cycle comprising by a fifth process and a sixth process is applied between the first electrode and the second electrode repeatedly,
wherein,
the fifth process in which the first electrode is grounded and a positive volyage is applied between the first electrode and the second electrode and
the sixth process in which the first electrode is grounded and a negative voltage is applied between the first electrode and the second electrode.

15. The method for manufacturing the oxide semiconductor secondary battery according to claim 1 or 14,
wherein a voltage is applied between the first electrode and the second electrode in a humidity environment with a humidity within 35 to 65%.
